# EUROPEAN PATENT APPLICATION

(11) **EP 3 993 572 A1**
(43) Date of publication of application: **04.05.2022**
(21) Application number: 20204233.9
(22) Date of filing: 28.10.2020
(51) Int. Cl.: H05K 1/11, H05K 1/14, H01L 23/498, H01L 23/00, H05K 3/36, H05K 3/34, H05K 1/02

(54) **WIRELESS MODULE AND COMBINATION OF WIRELESS MODULE AND CIRCUIT BOARD**

(71) Applicant: Tridonic GmbH & Co. KG, 6851 Dornbirn (AT)
(72) Inventor: Lochmann, Frank, 6850 Dornbirn (AT); Schertler, Markus, 6850 Dornbirn (AT); Mayrhofer, Markus, 6850 Dornbirn (AT); Simma, Lukas, 6850 Dornbirn (AT); Zengerle, Thomas, 6850 Dornbirn (AT); Schnell, Patrick, 6850 Dornbirn (AT)
(74) Representative: Rupp, Christian

(57) **Abstract**

A wireless module (1) for a lighting technology device (5) is provided. The device (5) comprises terminals (102, 104, 106, 108) being arranged on a bottom side (100) opposing a component side of the wireless module (1). The terminals (102, 104, 106, 108) have a plurality of footprints. A footprint of each of the terminals (102, 104, 106, 108) off a periphery of the bottom side (100) is less than or equal to a footprint of each of the terminals (102, 104, 106, 108) in the periphery of the bottom side (100). Further, combinations (2; 3; 4) of a wireless module (1) and a circuit board (200; 300; 400) are provided, as well as a lighting technology device (5) comprising such a combination (2; 3; 4).

## Description

The present disclosure relates to wireless modules for lighting applications, and in particular to such wireless modules in combination with various types of circuit boards.

Terminals of known wireless modules are typically arranged at side edges of the wireless modules. Since overall dimensions of wireless modules and thus dimensions of the side edges are constantly shrinking, there is no longer sufficient base available for arrangement of all required terminals. This issue is worsening if one wireless module shall be used in different applications requiring different terminal counts.

Accordingly, the object of the present application is to provide wireless modules which may be deployed in combination with various types of circuit boards.

The invention is defined by the appended independent claims. Preferred embodiments are set forth in the dependent claims and in the following description and drawings.

According to a first aspect, a wireless module for a lighting technology device comprises terminals being arranged on a bottom side opposing a component side of the wireless module. The terminals have a plurality of footprints. A footprint of each of the terminals off a periphery of the bottom side is less than or equal to a footprint of each of the terminals in the periphery of the bottom side.

Preferably, the terminals off the periphery are configured for connectivity to one or more inner conductor layers of a multi-layer circuit board connectable to the wireless module.

Preferably, the terminals in the periphery are configured for connectivity to one or more outer conductor layers of a circuit board connectable to the wireless module.

Preferably, the terminals in the periphery are configured for use in combination with the terminals off the periphery.

Preferably, the periphery comprises an all-around circumferential portion of the bottom side within a predetermined clearance to side edges thereof.

Preferably, the lighting technology device comprises a driver of a luminaire, or a sensor.

Preferably, the wireless module comprises a wireless chip, a wireless integrated circuit or a wireless system-on-chip.

Preferably, the wireless module comprises a circuit board forming the bottom side.

Preferably, the terminals comprise pads or pins.

According to a second aspect, a combination of a wireless module according to the first aspect and a single-layer circuit board is provided.

According to a third aspect, a combination of a wireless module according to the first aspect and a multi-layer circuit board is provided.

According to a fourth aspect, a lighting technology device comprises a combination according to the second or third aspects.

The present disclosure provides a wireless module which, by virtue of its terminal arrangement, avoids a lack of sufficient base available for arrangement of all required terminals of a particular application. More specifically, the terminal arrangement extensively occupies the bottom side of the wireless module by arranging terminals having a specific footprint for single-layer circuit board applications at the side edges of the bottom side, i.e., in a periphery of the bottom side, and arranging terminals having smaller or equal footprints for multi-layer circuit board applications off the periphery of the bottom side. Terminals of same or different footprint may be used in various combinations to enable different applications requiring different terminal counts.

Further aspects, advantages and objects of the invention will become evident for the skilled reader by means of the following detailed description of the embodiments of the invention, when taking into conjunction with the figures of the enclosed drawings.
Fig. 1 illustrates a bottom side of a wireless module according to an embodiment of the present disclosure;
Fig. 2 illustrates an exploded view of a combination according to an embodiment of the present disclosure of a wireless module and a single-layer circuit board;
Fig. 3 illustrates an exploded view of a combination according to an embodiment of the present disclosure of a wireless module and a dual-layer circuit board;
Fig. 4 illustrates an exploded view of a combination according to an embodiment of the present disclosure of a wireless module and a multi-layer circuit board;
Fig. 5 illustrates a schematic view of a lighting technology device according to an embodiment of the present disclosure comprising a combination according to an embodiment of the present disclosure.

The invention will now be described with respect to various embodiments. The features of these embodiments may be combined with each other unless specified otherwise. The same or similar reference numerals designate the same or similar elements throughout the drawings.

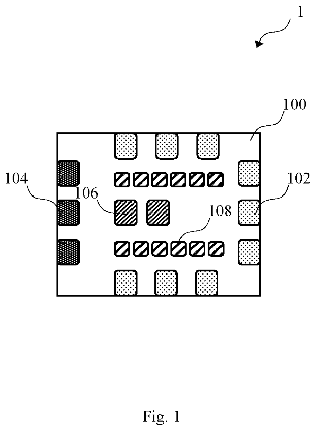

Fig. 1 illustrates a bottom side 100 of a wireless module 1 according to an embodiment of the present disclosure.

The bottom side 100 opposes a component side of the wireless module 1. The wireless module 1 may comprise a circuit board forming the bottom side 100.

As used herein, the terms "component side" and "bottom side" may refer to a respective one of two flat faces of a same circuit board facing away from each other. Circuit components of the wireless module 1 are arranged on the component side, and terminals are arranged on the bottom side 100 opposing the component side.

The wireless module 1 may comprise a wireless chip, a wireless integrated circuit or a wireless system-on-chip.

As used herein, the term "chip" or "die" may refer to a flat piece of processed single crystal semiconductor material comprising electronic circuits. Some of its die area may be dedicated for connecting terminals.

As used herein, the term "integrated circuit" may refer to the electronic circuits being integrated/processed into the aforementioned chip. A monolithic integrated circuit comprises the electronic circuits on a single chip. A hybrid integrated circuit combines multiple chips each comprising a portion of the electronic circuits. Integrated circuits may be enclosed in a package with connecting terminals.

As used herein, the term "system-on-chip" may refer to an integrated circuit comprising all or most components of an electronic system, such as a wireless module 1.

The wireless module 1 is suitable for a lighting technology device 5. The lighting technology device 5 may comprise a driver of a luminaire, or a sensor.

The wireless module 1 comprises terminals 102, 104, 106, 108 being arranged on the bottom side 100. The terminals 102, 104, 106, 108 may comprise pads or pins. In Fig. 1, the terminals 102, 104, 106, 108 comprise pads, i.e., solderable pads.

As may be taken from Fig. 1, the terminals 102, 104, 106, 108 have a plurality of footprints.

As used herein, the term "footprint" may refer to a surface area requirement on a flat face, and in particular to such a requirement of a terminal 102, 104, 106, 108 on the bottom side 100 of the wireless module 1.

The embodiment of Fig. 1 shows terminals 102, 104 having a first footprint, and terminals 106, 108 having a second footprint different from the first footprint. In other examples, the terminals 102, 104, 106, 108 may have more than two different footprints.

In the example of Fig. 1, three triplets of terminals designated as 102 (indicated by light dot pattern) are arranged at first to third side edges of the bottom side 100, and a triplet of terminals designated as 104 (indicated by dark dot pattern) is arranged at a fourth side edge thereof. In other words, the terminals 102, 104 having the first footprint are arranged in a periphery of the bottom side 100.

The periphery may comprise an all-around circumferential portion of the bottom side 100 within a predetermined clearance to side edges thereof. For example, the predetermined clearance to the side edges of the bottom side 100 may be dimensioned such that the periphery accommodates the terminals 102, 104 only.

The terminals 102, 104 in the periphery may be configured for connectivity to one or more outer conductor layers of a circuit board 200; 300; 400 connectable to the wireless module 1.

The terminals designated as 102 may be used for programming, communication (e.g., Digital Addressable Lighting Interface / DALI, serial) and/or powering purposes, for example.

The terminals designated as 104 may be used for connecting to an optional external antenna.

With continuing reference to the example of Fig. 1, a pair of terminals 106 (indicated by closely striped pattern) having the first footprint and two sextets of terminals 108 (indicated by loosely striped pattern) having the second footprint are arranged on the bottom side 100 in between the terminals 102, 104. That is to say, the terminals 106, 108 having the first and second footprints are arranged off the periphery of the bottom side 100.

The terminals 106, 108 off the periphery may be configured for connectivity to one or more inner conductor layers of a multi-layer circuit board 300; 400 connectable to the wireless module 1.

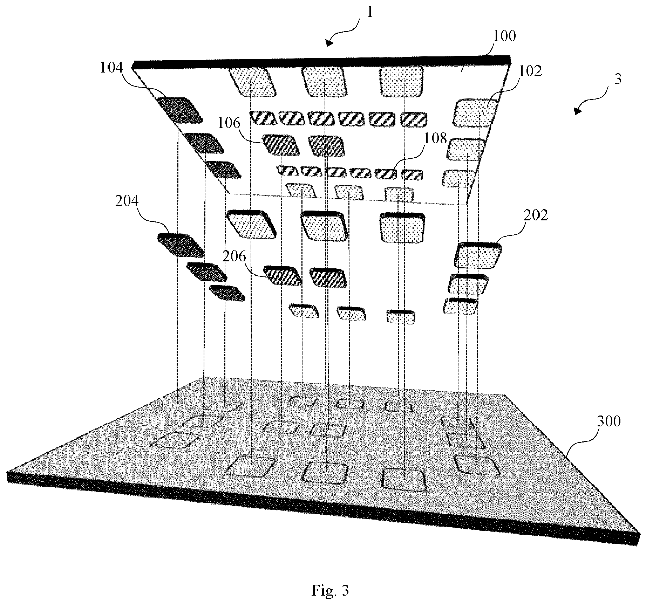

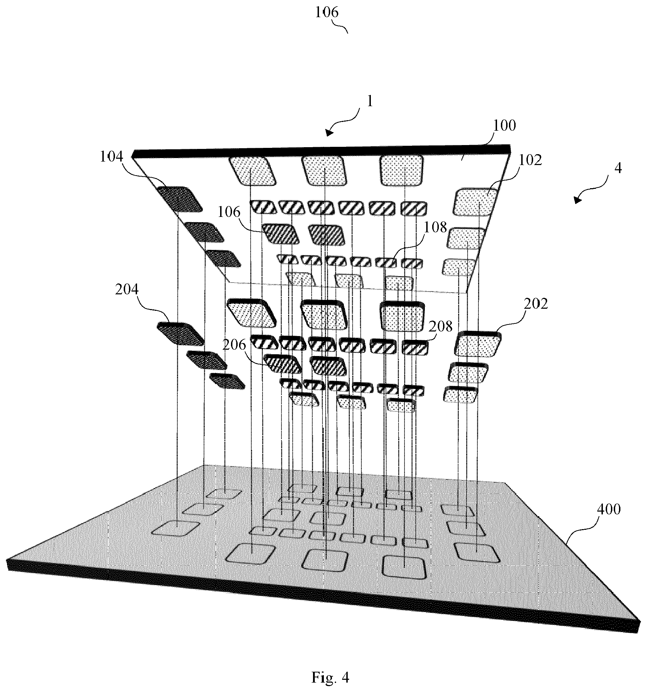

More specifically, the terminals designated as 106 may be used e.g. for additional switching in combination with multi-layer circuit board 300, and the terminals designated as 108 may be used e.g. for wireless sensors in combination with multi-layer circuit boards 400, as will be explained in more detail in connection with Figs. 3 and 4.

Still referencing Fig. 1, it is shown that the footprint of each of the terminals 106, 108 off the periphery of the bottom side 100 is less than or equal to the footprint of each of the terminals 102, 104 in the periphery of the bottom side 100.

This enables having more terminals on the bottom side 100 of the wireless module 1, by arranging additional terminals 106, 108 off the periphery of the bottom side 100, and by providing terminals 108 having a footprint that is less than the footprint of each of the terminals 102, 104 in the periphery of the bottom side 100.

The terminals 102, 104 in the periphery may be configured for use in combination with the terminals 106, 108 off the periphery, as will become more apparent in connection with Figs. 3 and 4.

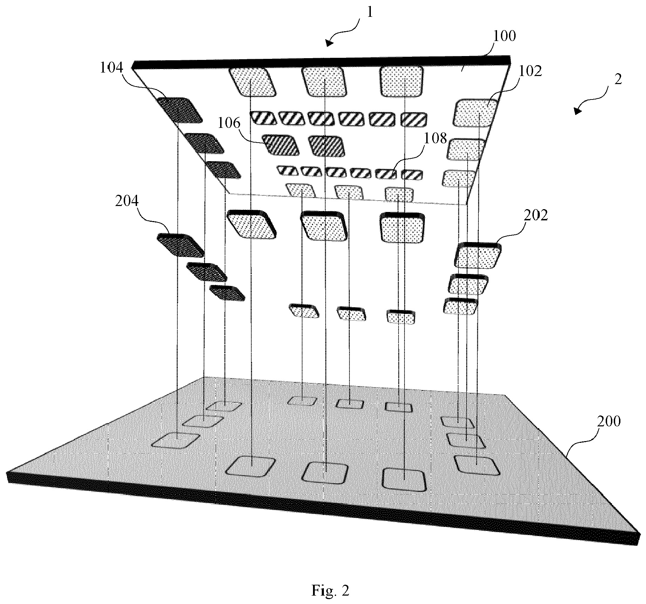

Fig. 2 illustrates an exploded view of a combination 2 according to an embodiment of the present disclosure of a wireless module 1 and a single-layer circuit board 200.

An upper part of Fig. 2 shows the wireless module 1 comprising the bottom side 100 and the terminals 102, 104, 106, 108, as previously described.

A lower part of Fig. 2 represents the single-layer circuit board 200.

In this embodiment, the terminals 106, 108 off the periphery of the bottom side 100 are not used, and the terminals 102, 104 in the periphery may be configured for connectivity to one or more outer conductor layers of a circuit board 200; 300; 400 connectable to the wireless module 1. As such, the circuit board 200 may as well be substituted by a dual-layer circuit board 300 or a multi-layer circuit board 300 having more than two conductor layers, as each of these circuit boards 200; 300; 400 comprises one or more outer conductor layers.

A central part of Fig. 2 indicates solder material 202, 204 used to electrically interconnect the terminals 102, 104 in the periphery of the bottom side 100 of the wireless module 1 and corresponding contact areas of the single-layer circuit board 200. Dotted lines indicate these contact areas as projections of respective pairs of terminals 102, 104 and solder material 202, 204 onto a flat side of the single-layer circuit board 200.

This embodiment enables using the wireless module 1 in a low-cost application requiring only 9 (or 12) terminals, depending on a deployment of the optional external antenna.

Fig. 3 illustrates an exploded view of a combination 3 according to an embodiment of the present disclosure of a wireless module 1 and a dual-layer circuit board 300.

An upper part of Fig. 3 shows the wireless module 1 comprising the bottom side 100 and the terminals 102, 104, 106, 108, as previously described.

A lower part of Fig. 3 represents the dual-layer circuit board 300.

In this embodiment, the terminals 102, 104 in the periphery may be configured for use in combination with the terminals 106 off the periphery, while the terminals 108 off the periphery of the bottom side 100 are not used.

With respect to Fig. 2, a central part of Fig. 3 indicates additional solder material 206 used to electrically interconnect the terminals 106 off the periphery of the bottom side 100 of the wireless module 1 and corresponding contact areas of the dual-layer circuit board 300. Dotted lines indicate these contact areas as projections of respective pairs of terminals 106 and solder material 206 onto a flat side of the dual-layer circuit board 300.

This embodiment enables re-using the wireless module 1 described in Figs. 1 - 2 in a further low-cost application requiring only 11 (or 14) terminals, depending on a deployment of the optional external antenna. For example, this may be an application involving a wireless-enabled driver of a luminaire.

Fig. 4 illustrates an exploded view of a combination 4 according to an embodiment of the present disclosure of a wireless module 1 and a multi-layer circuit board 400.

An upper part of Fig. 4 shows the wireless module 1 comprising the bottom side 100 and the terminals 102, 104, 106, 108, as previously described.

A lower part of Fig. 4 represents the multi-layer circuit board 400 having more than two conductor layers (i.e., having one or more inner conductor layers).

In this embodiment, the terminals 102, 104 in the periphery may be configured for use in combination with the terminals 106, 108 off the periphery. More specifically, all terminals 102, 104, 106, 108 are used, and the terminals 108 off the periphery may be configured for connectivity to the one or more inner conductor layers of the multi-layer circuit board 400 connectable to the wireless module 1.

With respect to Fig. 3, a central part of Fig. 4 indicates additional solder material 208 used to electrically interconnect the terminals 108 off the periphery of the bottom side 100 of the wireless module 1 and corresponding contact areas of the multi-layer circuit board 400. Dotted lines indicate these contact areas as projections of respective pairs of terminals 108 and solder material 208 onto a flat side of the multi-layer circuit board 400.

This embodiment enables re-using the wireless module 1 described in Figs. 1 - 3 in a further application requiring 23 (or 26) terminals, depending on a deployment of the optional external antenna. For example, this may be an application involving a wireless sensor in combination with the multi-layer circuit board 400.

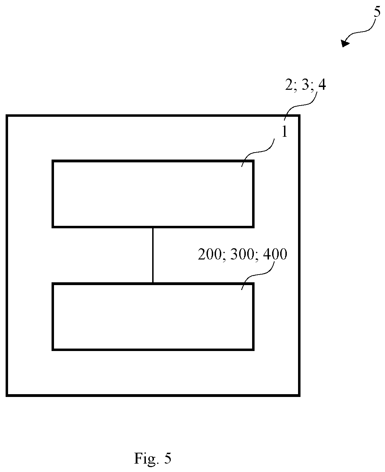

Fig. 5 illustrates a schematic view of a lighting technology device 5 according to an embodiment of the present disclosure comprising a combination 2; 3; 4 according to an embodiment of the present disclosure.

The lighting technology device 5 may comprise a driver of a luminaire, or a sensor.

The combination 2; 3; 4 is explained in connection with Figs. 2 - 4 above. In turn, the combination 2; 3; 4 comprises a wireless module 1 as explained in connection with Fig, 1 and a corresponding circuit board 200; 300; 400.

As such, the technical effects and advantages mentioned in connection with the wireless module 1 and the combination 2; 3; 4 also apply for the lighting technology device 5.

## Claims

1. A wireless module (1) for a lighting technology device (5), comprising terminals (102, 104, 106, 108) being arranged on a bottom side (100) opposing a component side of the wireless module (1);
the terminals (102, 104, 106, 108) having a plurality of footprints;
a footprint of each of the terminals (106, 108) off a periphery of the bottom side (100) is less than or equal to a footprint of each of the terminals (102, 104) in the periphery of the bottom side (100).

2. The wireless module (1) of claim 1,
wherein the terminals (106, 108) off the periphery are configured for connectivity to one or more inner conductor layers of a multi-layer circuit board (300; 400) connectable to the wireless module (1).

3. The wireless module (1) of claim 1 or claim 2,
wherein the terminals (102, 104) in the periphery are configured for connectivity to one or more outer conductor layers of a circuit board connectable to the wireless module (1).

4. The wireless module (1) of any of the preceding claims,
wherein the terminals (102, 104) in the periphery are configured for use in combination with the terminals (106, 108) off the periphery.

5. The wireless module (1) of any of the preceding claims,
wherein the periphery comprises an all-around circumferential portion of the bottom side (100) within a predetermined clearance to side edges thereof.

6. The wireless module (1) of any of the preceding claims,
wherein the lighting technology device (5) comprises a driver of a luminaire, or a sensor.

7. The wireless module (1) of any of the preceding claims,
wherein the wireless module (1) comprises a wireless chip, a wireless integrated circuit or a wireless system-on-chip.

8. The wireless module (1) of any of the preceding claims,
wherein the wireless module (1) comprises a circuit board forming the bottom side (100).

9. The wireless module (1) of any of the preceding claims,
wherein the terminals (102, 104, 106, 108) comprise pads or pins.

10. A combination (2) of a wireless module (1) according to any of claims 1 to 9 and a single-layer circuit board (200).

11. A combination (3; 4) of a wireless module (1) according to any of claims 1 to 9 and a multi-layer circuit board (300; 400).

12. A lighting technology device (5) comprising a combination (2; 3; 4) according to claim 10 or claim 11.
